Europäisches Patentamt

European Patent Office

Office européen des brevets

(11) Publication number: **0 031 715**
**B1**

(12) **EUROPEAN PATENT SPECIFICATION**

(45) Date of publication of patent specification: **30.09.87**

(51) Int. Cl.⁴: **G 11 C 11/40**

(21) Application number: **80304698.6**

(22) Date of filing: **23.12.80**

(54) **A semiconductor memory having a power-down function.**

(30) Priority: **25.12.79 JP 169067/79**

(43) Date of publication of application:
**08.07.81 Bulletin 81/27**

(45) Publication of the grant of the patent:
**30.09.87 Bulletin 87/40**

(84) Designated Contracting States:
**DE FR GB**

(56) References cited:
**US-A-3 953 839**
**US-A-4 123 799**

**IEEE INT. SOLID STATE CIRCUITS CONF., vol.
22, no. (02-79), February 15, 1979, pages
100-101,285, New York, US. R. M. JECMEN et
al.: "A 25ns 4K static RAM"**

(73) Proprietor: **FUJITSU LIMITED**
**1015, Kamikodanaka Nakahara-ku
Kawasaki-shi Kanagawa 211 (JP)**

(72) Inventor: **Shimada, Hiroshi**
**No. 33-3, Kitashinjuku, 4-chome Shinjuku-ku
Tokyo, 160 (JP)**

(74) Representative: **Sunderland, James Harry et al
HASELTINE LAKE & CO Hazlitt House
28 Southampton Buildings Chancery Lane
London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a semiconductor memory.

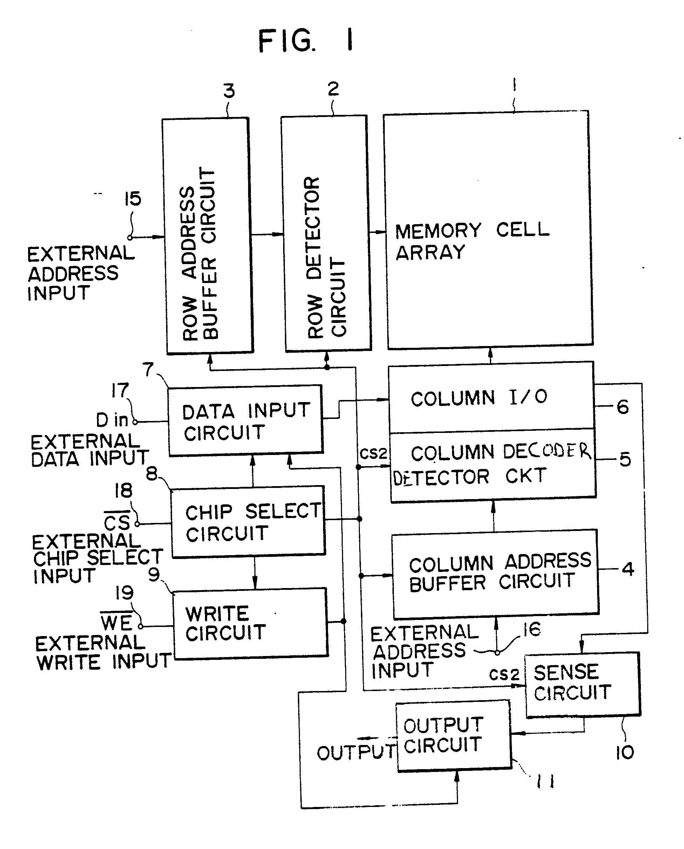

Figure 1 of the accompanying drawings, which is a schematic block diagram, shows a known static RAM which adopts a power-down mode. In Figure 1, an external address input which is applied to a terminal 15 is delivered to a row address buffer circuit 3 and the internal address output provided by circuit 3 is supplied to a row decoder circuit 2, wherein it selects a row of a memory cell array 1. In a similar manner, an external address input to a terminal 16 is applied via a column address buffer circuit 4 to a column decoder circuit 5 for the selection of a column of the memory cell array 1. External data Din which is delivered to a terminal 17 is applied to a data input circuit 7, whereby valid data is written in a selected cell of the memory cell array 1. An external chip select input $\overline{CS}$ delivered to a terminal 18 is applied via a chip select circuit 8 (as CS2) to the row decoder circuit 2, the column address buffer circuit 4, the column decoder circuit 5 and a sense circuit 10 to control them in order to save power. An external write input delivered to a terminal 19 is supplied via a write circuit 9 to the data input circuit 7 and output circuit 11 to control them. Further, the chip select circuit 8 controls the data input circuit 7 and the write circuit 9 at the same time. A column I/O circuit 6 controls write and read of the memory cell array 1.

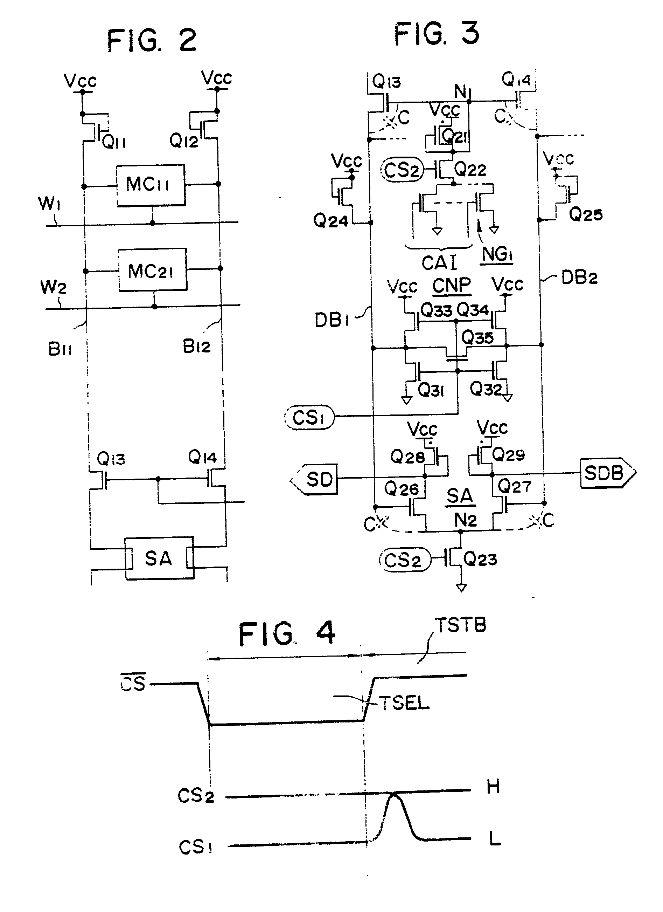

A memory cell array constitutes a static semiconductor memory, when memory cells, each constituted by a flip-flop, are respectively connected to intersections of pluralities of word lines and bit line pairs. Figure 2 of the accompanying drawings, which is a schematic circuit diagram, shows a part of a static semiconductor memory. In Figure 2, W1, W2,..... are word lines; B11 and B12 designate a pair of bit lines (a bit line pair); and MC11, MC21,... are memory cells respectively connected to the intersections of the word lines and the bit lines. The pair of bit lines B11 and B12 are each connected at one end to a power source Vcc respectively via transistors Q11 and Q12 serving as load and each is connected at the other end to a sense amplifier SA respectively via transistors Q13 and Q14 forming transfer gates for column (bit line) selection use.

In a static memory which adopts a power-down mode, a circuit for the transfer gates Q13 and Q14 and the sense amplifier SA is arranged as shown in Figure 3. In a column decoder (a NOR gate NG1 for column selection use) a transistor Q22, which is turned ON and OFF by a signal CS2 derived from a chip select signal (see Figure 1), is connected between a gate for receiving a column address input CAI and a load transistor Q21, and when a chip including the illustrated memory cell is not selected, the transistor Q22 is held in an OFF state, preventing power consumption by the NOR gate NG1. Also, in the sense amplifier SA, a transistor Q23 which is turned ON and OFF by the signal CS2 is provided to prevent power consumption by the sense amplifier SA when the chip is not selected. DB1 and DB2 are data buses, which are also connected to other bit line pairs via transfer gates (not shown) similar to Q13 and Q14. Q24 and Q25 are transistors which are connected between the power source Vcc and the data buses to supply potentials to the data buses so that they do not float. SD and SDB are a pair of outputs or buses.

In this memory circuit, when the chip is selected, the signal CS2 is high-level and the transistor Q22 is in an ON state. When the illustrated column of the memory is selected, the NOR gate NG1 is turned OFF and when the column is not selected, the NOR gate NG1 is in an ON state. When the NOR gate NG1 is in the OFF state, the transistors Q13 and Q14 are turned ON by a high-level voltage of the power source Vcc applied thereto via the load transisotr Q21. In consequence, the potentials of the bit lines B11 and B12 which become high- or low-level dependent upon the stored content of a memory cell along the bit lines and along a selected word line are transmitted to the data buses DB1 and DB2 and amplified by the sense amplifier SA and then output to the buses SD and SDB. If the illustrated column is not selected, the NOR gate NG1 is held in the ON state, so that the transistors Q13 and Q14 have their gates grounded, disconnecting the bit lines B11 and B12 from the data buses DB1 and DB2.

Since the transistors Q13 and Q14 are of the enhancement type (depletion type transistors being marked by a dot in the Figures), when they are in the ON state (their gate potentials being equal to the power source potential), the potentials of the bit lines B11 and B12 are reduced by a threshold voltage Vth of each of the transistors Q11, Q12, and Q13, Q14 and Q24, Q25 and data is applied from the bit lines B11 and B12 to the data buses DB1 and DB2 at that reduced potential.

Now, let it be assumed that the chip including the illustrated memory cell column is switched to a nonselected (standby) state from a selected state. Between the gate and the source-drain path of each of the transistors Q13 and Q14 there exists an electrostatic capacitance C due to an overlap. When the gate potentials of the transistors Q13 and Q14 are low-level, that is, when the chip is selected but the column is not selected, the capacitances C are charged up to the potentials of the data buses DB1 and DB2. In this state, when the chip becomes nonselected (standby), the signal CS2 becomes low-level and the transistor Q22 is turned OFF, so that the gate potentials of the transistors Q13 and Q14 rise up to the voltage level of the power source Vcc. This not only turns ON the transistors Q13 and Q14 but also causes a bootstrap operation, whereby the data buses DB1 and DB2 are charged by way of the power source, the transistors Q21 and the charged capacitances C up to a level higher than the level (Vcc-Vth) which is reduced by the threshold voltage Vth of the transistors Q13 and Q14 from power source Vcc level. Since a conventional memory is not provided with a discharge circuit for removing this overcharging of the data buses, they remain in this ultra-high level state.

Overcharging of data buses DB1 and DB2 is also effected by the sense amplifier SA. Between the gates and the source-drain paths of transistors Q26 and Q27 making up the sense amplifier SA, too, there exists overlap capacitances C. When the signal CS2 is high-level and the transistor Q23 is in the ON state, that is, when the sense amplifier SA is in operation, the capacitances C are charged by differences between the potentials of the data buses DB1 and DB2 and the potential at a node N2, i.e. the connection point of the source of the transistors Q26 and Q27. When the chip becomes nonselected, the transistor Q23 is turned OFF and the potential at the node N2 is raised by load transistors Q28 and Q29 and the driven transistors Q26 and Q27 towards the power source potential and, as a result of the charges stored in the capacitances C, the data buses DB1 and DB2 are overcharged.

If the potentials of the data buses are raised too high, there is a possibility that when a chip selection and a column selection are made, the sense amplifier SA will read first a difference between previous data selected in a previous cycle, with the result that access in the chip select mode will lag behind the time at which access could be made in a case in which the buses were not charged up by stored charged couplings.

Attention is directed to IEEE. Int. Solid State Circuits Conference, 1976, Digest of Technical Papers, pp 136/137, Schlageter et al, "A 4K Static 5-V RAM, to US—A—4 123 799, which is concerned with precharging of bit lines in a static IGFET RAM, and IEEE Int. Solid State Circuits Conference, Vol. 22, No. (02—79), 15 February 1979, pages 100 and 101 and 285, which is concerned with a static RAM with a power-down mode.

According to the present invention there is provided a static semiconductor memory, operable with a first power supply voltage and a second power supply voltage lower than the first power supply voltage, and having a power-down mode, including a plurality of memory cells connected to corresponding word lines and connected in parallel to a bit line pair, transfer gates connected to the bit lines of the bit line pair and operable to connect those bit lines to first ends of respective buses of a data bus pair, and a sense amplifier operatively connected to second ends of the respective buses of the data bus pair, characterised in that the memory further comprises a coupling noise canceller connected to the data bus pair for discharging the respective buses of the data bus pair to the second power supply voltage and for clamping those buses to a predetermined potential, when the memory is switched to a power-down mode, wherein the coupling noise canceller comprises two transistors having their source-drain paths connected between the respective data buses of the data bus pair and the second power supply voltage, and having their gates arranged for receiving a noise canceller control signal for turning those transistors on to discharge those data buses to the second power supply voltage.

An embodiment of the present invention can offer a solution to the abovedescribed problem encountered in a conventional static memory.

Briefly, in an embodiment of this invention a coupling noise canceller is provided which is connected to a data bus connected at one end to a bit line via a transfer gate and at the other end to a sense amplifier and which, when the bit line becomes nonselected, operates to clamp the data bus to a predetermined potential before the transfer gate and the sense amplifier are turned OFF.

Reference is made, by way of example, to the accompanying drawings, in which:-

Figure 1 is a schematic block diagram illustrating a conventional static RAM which adopts a power-down mode;

Figure 2 is a schematic circuit diagram illustrating a memory cell part of the memory shown in Figure 1;

Figure 3 is a schematic circuit diagram of a data bus part of an embodiment of the present invention (parts of Figure 3 are referred to for explanation of the conventional static RAM);

Figure 4 is a schematic time chart diagram explanatory of signal timings;

Figure 5 is a schematic circuit diagram illustrating another embodiment of the present invention; and

Figures 6A and 6B provide a potential distribution diagram for assistance in explanation of the influence of coupling of a chip select signal on a data bus in the circuit shown in Figure 3.

Figure 3 shows a circuit arrangement of parts concerned with reading out of signals from a memory cell array. In Figure 3, a circuit CNP constituted by transistors Q31 to Q35 is a coupling noise canceller for data buses DB1 and DB2. The transistors Q31 and Q32 are for discharging charges of the data buses DB1 and DB2 to ground, for preventing an abnormal potential rise, and the transistor Q35 short-circuits the data buses DB1 and DB2 to make them equipotential. These transistors are turned ON and OFF by a signal CS1 which is derived from the chip select signal $\overline{CS}$. Figure 4 shows the phase relationships of the signals $\overline{CS}$, CS1 and CS2. When the signal $\overline{CS}$ is in a select state in a period TSEL, the signal CS2 is high-level and the signal CS1 is low-level, holding the coupling noise canceller out of operation. When the signal $\overline{CS}$ is changed over to a non-select state, i.e. in a standby period TSTB after the select period TSEL, the signal CS1 rises to turn ON the transistors Q31, Q32 and Q35, suppressing the data buses DB1 and DB2 to a predetermined voltage. Thereafter, the signal CS2 falls; accordingly, by the provision of such timing for signals CS1 and CS2, abnormal potential rise of the data buses can itself be inhibited.

The transistors Q33 and Q34 divide the voltage of the power source Vcc, together with the transistors Q31 and Q32, thus functioning to hold the voltages of the data buses DB1 and DB2 during the standby period to the level Vcc-Vth.

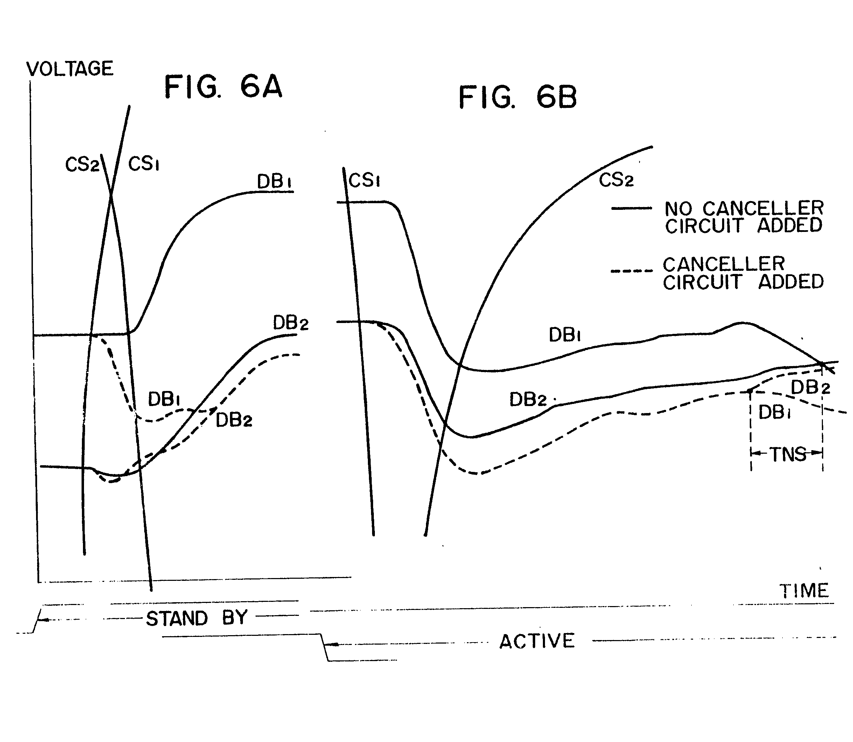

A description will be given, with reference to Figures 6, of the above described operating state.

In Figure 3, when the memory is changed over to a standby state from an active state, the signal CS2 for power-down use, which is applied to the decoder, the sense amplifier SA and so forth, becomes low-level, putting each buffer system (not shown) in a power-down mode. In the standby state, (when no coupling noise canceller according to the present invention is provided the potential at an output point N1 of the column decoder rises up to the power source voltage Vcc and in the sense amplifier SA, too, the potential at a node N2 assumes a high level which is determined by the sense amplifier SA. Accordingly, there occurs coupling between the transistor Q13 and the data bus DB1 and between the transistor Q14 and the data bus DB2 due to overlap and, also on the side of the sense amplifier SA, there occurs coupling due to the capacitances C indicated by broken lines (in Figure 3).

As a result, the potential of each data bus is raised higher than the load level which is dependent on the level Vcc-Vth, and stored charges are not discharged. This state is shown by the solid lines (DB1, DB2) in Figure 6A. The bit line level is about (Vcc-Vth) but the bus line level rises higher than (Vcc-Vth) and the potential difference between the data buses in the memory active state remains unchanged. When the memory becomes active again (see Figure 6B), the potential difference is retained to some extent and the bus line moves after a time lag TNS, leading to a lag in access time.

Next, a description will be given of a case in which a coupling noise canceller CNP in accordance with the present invention is provided. To the coupling noise canceller CNP is supplied the signal CS1. When the memory is changed to the standby state, the signal CS1 rapidly rises up to the power source voltage level Vcc to turn ON the coupling noise canceller CNP before the signal CS2 becomes low-level and Q22, Q23 are cut off. At that moment, even if the signal CS2 is cut off, to cause coupling, charges resulting from this coupling are discharged via the transistors Q31 and Q32 to ground, providing a state in which effectively, no coupling is produced. The broken lines in Figures 6A and 6B show such an effect. When the signal CS1 rises up, even if the signal CS2 becomes low-level and Q22, Q23 are cut off, the bus line levels DB1 and DB2 stay equal as indicated by broken lines.

Accordingly, in a case where the standby period is long, there does not occur a lag in access time due to coupling.

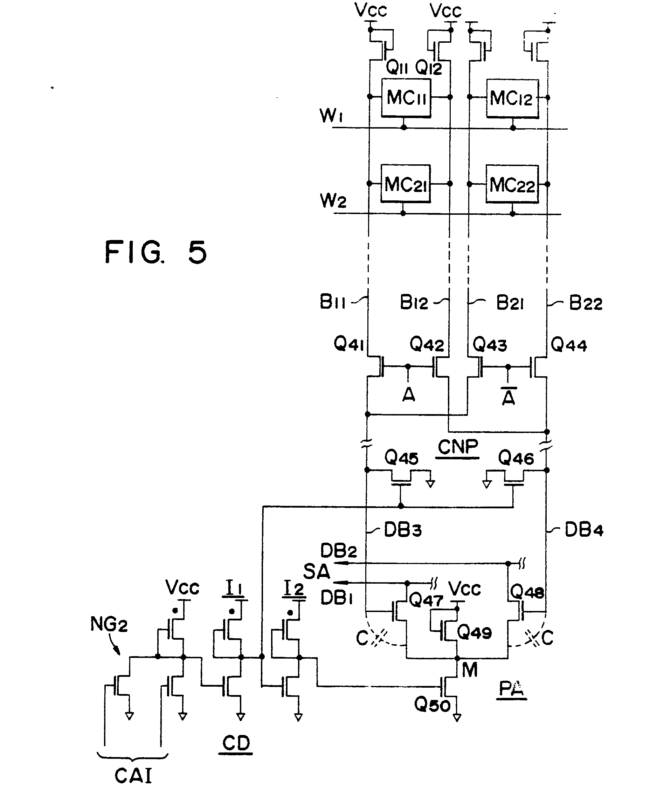

Figure 5 illustrates a part of another embodiment of the present invention. Two pairs of bit lines shown in the illustrated part constitute a set of bit lines and a pre-amplifier PA is provided for each set. CD is a column decoder. When the chip on which the bit lines of Figure 5 are provided is selected, the output from a NOR gate NG2 becomes high-level, the output from an inverter I1 becomes low-level, the output from an inverter I2 becomes high-level and a transistor Q50 of the pre-amplifier PA is turned ON to put it into operation. In bit line pairs B11, B12 and B21, B22 there are respectively inserted pairs of transfer gates Q41, Q42, and Q43, Q44, which are turned ON and OFF by a least significant bit signal A of the column address input CAI and the inverted signal $\bar{A}$. For example, when the least significant bit signal A is high-level, the transfer gates Q41 and Q42 are turned ON to connect the pair of bit lines B11 and B12 to sub data buses DB3 and DB4, whereas when the least significant bit signal A is low-level, the transfer gates Q43 and Q44 are turned ON to connect the pair of bit lines B21 and B22 to the sub data buses DB3 and DB4.

In such a memory, too, when the chip becomes nonselected, the transistor Q50 is turned OFF and the potential at a node M is raised by a load transistor Q49 up to the power source voltage level Vcc and, in consequence, capacitances C between the gates and the source-drain paths of transistors Q47 and Q48, charged while the chip was selected, raise the potentials of the data buses DB1 and DB2. Transistors Q45 and Q46 inserted between the sub data buses DB3 and DB4 and ground and the two inverters I1 and I2 provided at the output end of the column decoder CD are to inhibit this potential rise. That is, a control signal for the transistor Q50 of the pre-amplifier PA may be derived directly from a NOR gate NG1 of the column decoder CD, but two stages of inverters are provided to provide a time delay and the transistors Q45 and Q46 are turned ON and OFF by the inverter of the first stage. With such an arrangement, when the chip is changed from the selected state to the nonselected state, the transistors Q45 and Q46 are turned ON first to hold the sub data buses DB3 and DB4 at voltages obtained by dividing the voltage of the power source Vcc by the transistors Q11, Q12 and Q45, Q46, respectively. Only then is the transistor Q50 turned OFF and, at this time, rising of the potentials of the sub data buses by the stored charges in charged capacitances C is prevented by discharging the stored charges to ground via the transistors Q45 and Q46 which are already in the ON state.

As has been described above, in an embodiment of the present invention, since there is provided a circuit which prevents coupling noise resulting from gate capacitances of transistors connected to data buses, that is, overcharging of the data buses when the memory chip is changed from the selected state to the unselected state, it is possible to inhibit an increase in access time (a time lag) when the memory chip is changed from the nonselected state to the selected state. An embodiment of the present invention can be of great utility when put into practical use. Further, since the coupling noise canceller provided in an embodiment of this invention operates first when the memory chip is changed to the nonselected state, overcharging of the data buses is prevented in the first place; therefore, the coupling noise canceller is very effective in a case in which chip selection and nonselection are repeated frequently.

**Claims**

1. A static semiconductor memory, operable with a first power supply voltage (Vcc) and a second power supply voltage lower than the first power supply voltage, and having a power-down mode, including a plurality of memory cells ($MC_{11}$, $MC_{12}$, $MC_{21}$, $MC_{22}$) connected to corresponding word lines ($W_1$, $W_2$) and connected in parallel to a bit line pair ($B_{11}$, $B_{12}$, $B_{21}$, $B_{22}$), transfer gates $Q_{13}$, $Q_{14}$, $Q_{41}$, $Q_{42}$, $Q_{43}$, $Q_{44}$) connected to the bit lines of the bit line pair and operable to connect those bit lines to first ends of respective buses of a data bus pair ($DB_1$, $DB_2$, $DB_3$, $DB_4$), and a sense amplifier (SA) operatively connected to second ends of the respective buses of the data bus pair,
characterised in that the memory further comprises a coupling noise canceller (CNP) connected to the data bus pair ($DB_1$, $DB_2$, $DB_3$, $DB_4$) for discharging the respective buses of the data bus pair to the second power supply voltage and for clamping those buses to a predetermined potential, when the memory is switched to a power-down mode, wherein the coupling noise canceller (CNP) comprises two transistors ($Q_{31}$, $Q_{32}$, $Q_{45}$, $Q_{46}$) having their source-drain paths connected between the respective data buses of the data bus pair ($DB_1$, $DB_2$, $DB_3$, $DB_4$) and the second power supply voltage, and having their gates arranged for receiving a noise canceller control signal ($CS_1$) for turning those transistors on to discharge those data buses to the second power supply voltage.

2. A memory as claimed in claim 1, further comprising a column decoder (NG1), connected to the bit line pair ($B_{11}$, $B_{12}$) and having a power-down mode, arranged for controlling the transfer gates ($Q_{13}$, $Q_{14}$), and wherein the coupling noise canceller (CNP) is arranged to operate immediately before the column decoder (NG1) commences a power-down operation.

3. A memory as claimed in claim 2, wherein the column decoder (NG1) comprises a plurality of parallel-connected transistors arranged for receiving column address input signals (CAI) at their gates, having their sources connected for receiving the second power supply voltage and having their drains connected in common, and a depletion-type transistor ($Q_{21}$) having its gate connected to its source and its drain connected for receiving the first power supply voltage (Vcc).

4. A memory as claimed in claim 3, wherein the column decoder (NG1) further comprises a control transistor ($Q_{22}$), connected between the source of the depletion-type transistor ($Q_{21}$) and the commonly-connected drains of the said plurality of parallel-connected transistors, having its gate arranged for receiving a control signal ($CS_2$) for bringing the column decoder into its power-down mode by turning the control transistor ($Q_{22}$) off.

5. A memory as claimed in any previous claim, wherein the sense amplifier (SA) has a power-down mode, and wherein the coupling noise canceller is arranged to operate immediately before the sense amplifier (SA) commences a power down operation.

6. A memory as claimed in claim 5, wherein the sense amplifier (SA) comprises two depletion-type load transistors ($Q_{28}$, $Q_{29}$) and two driven transistors ($Q_{26}$, $Q_{27}$), each load transistor ($Q_{28}$, $Q_{29}$) having its source-drain path connected in series with the source-drain path of a respective driven transistor ($Q_{26}$, $Q_{27}$) between the first power supply voltage and a node ($N_2$), each load transistor having its gate connected to the common connection point of its source-drain path with that of the series connected source-drain path of a driven transistor and each driven transistor having its gate connected to a respective data bus of the data bus pair ($DB_1$, $DB_2$), the sense amplifier (SA) further comprising a control transistor ($Q_{23}$) having its source-drain path connected between the said node ($N_2$) and the second power supply voltage, and having its gate arranged for receiving a control signal ($CS_2$) for bringing the sense amplifier into its power-down mode by turning the control transistor ($Q_{23}$) off.

7. A memory as claimed in any one of claims 1 to 6, wherein the coupling noise canceller (CNP) further comprises load means ($Q_{33}$, $Q_{34}$) connected between the first power supply voltage (Vcc) and the data buses of the data bus pair ($DB_1$, $DB_2$), operable for coupling those buses to the predetermined potential, and shorting means ($Q_{35}$) connected between the data buses of the data bus pair ($DB_1$, $DB_2$) operable for equalising the potentials of those data buses.

8. A memory as claimed in claim 7, wherein said load means comprises two transistors ($Q_{33}$, $Q_{34}$) having their source-drain paths connected between the first power supply voltage (Vcc) and the respective data buses of the data bus pair ($DB_1$, $DB_2$) and having their gates connected for receiving the noise canceller control signal ($CS_1$), and the said shortling means comprises a transistor ($Q_{35}$), having its source-drain path connected between the respective data buses of the data bus pair ($DB_1$, $DB_2$) and having its gate connected to receive the noise canceller control signal ($CS_1$).

9. A memory as claimed in claim 1, further comprising a preamplifier (PA), connected between the data buses of the data bus pair ($DB_3$, $DB_4$) and the sense amplifier (SA), and having a power-down mode.

10. A memory as claimed in claim 9, further comprising a column decoder (CD) operable to provide the noise canceller control signal and to provide a control signal for powering-down the preamplifier (PA).

11. A memory as claimed in claim 10, wherein the column decoder (CD) comprises a NOR gate (NG2) having inputs arranged for receiving column address input signals (CAI), a first inverter (I1) having an input arranged for receiving the output of the NOR gate (NG2) and an output providing the noise canceller control signal, and a second inverter (I2) having an input arranged for receiving the output of the first inverter and an output providing the control signal for the preamplifier (PA).

12. A memory as claimed in claims 10 or 11, wherein the preamplifier (PA) comprises a load transistor ($Q_{49}$) having its source-drain path connected between the first power supply voltage (Vcc) and a node (M) and having its gate connected to the first power supply voltage (Vcc), a control transistor ($Q_{50}$), having its source-drain path connected between the node (M) and the second power supply voltage and its gate connected for receiving the control signal for powering down the preamplifier (PA), and two further transistors ($Q_{47}$, $Q_{48}$), each having its source-drain path connected between the sense amplifier (SA) and the node (M) and its gate connected to a respective data bus of the data bus pair ($DB_3$, $DB_4$).

**Patentansprüche**

1. Statischer Halbleiterspeicher, der mit einer ersten Energieversorgungsspannung (Vcc) und einer zweiten Energieversorgungsspannung, die niedriger als die erste Energieversorgungsspannung ist, betreibbar ist, und einen Abschaltmodus hat, mit einer Vielzahl von Speicherzellen ($MC_{11}$, $MC_{12}$, $MC_{21}$, $MC_{22}$), die mit entsprechenden Wortlietungen ($W_1$, $W_2$) verbunden und parallel zu einem Bitleitungspaar ($B_{11}$, $B_{12}$, $B_{21}$, $B_{22}$) angeschlossen sind, Transfergates ($Q_{13}$, $Q_{14}$, $Q_{41}$, $Q_{42}$, $Q_{43}$, $Q_{44}$), die mit den Bitleitungen des Bitleitungspaares verbunden und betreibbar sind, um jene Bitleitungen mit ersten Enden von jeweiligen Bussen eines Datenbuspaares ($DB_1$, $DB_2$, $DB_3$, $DB_4$) zu verbinden, und einem Leseverstärker (SA), der wirkungsmäßig mit den zweiten Enden der jeweiligen Busse des Datenbuspaares verbunden ist,

dadurch gekennzeichnet, daß der Speicher ferner einen Kopplungsrauschenlöscher (CNP) umfaßt, der mit dem Datenbuspaar ($DB_1$, $DB_2$, $DB_3$, $DB_4$) verbunden ist, um die jeweiligen Busse des Datenbuspaares an die zweite Energieversorgungsspannung zu entladen und um jene Busse auf ein vorbestimmtes Potential zu klammern, wenn der Speicher in einen Abschaltmodus geschaltet wird, wobei der Kopplungsrauschenlöscher (CNP) zwei Transistoren ($Q_{31}$, $Q_{32}$, $Q_{45}$, $Q_{46}$) umfaßt, deren Source-Drain-Wege zwischen den jeweilgen Datenbussen des Datenbuspaares ($DB_1$, $DB_2$, $DB_3$, $DB_4$) und der zweiten Energieversorgungsspannung angeschlossen sind, und deren Gates angeordnet sind, um ein Rauschlöschungs-Steuersignal ($CS_1$) zu empfangen, um jene Transistoren einzuschalten, um jene Datenbusse an die zweite Energieversorgungsspannung zu entladen.

2. Speicher nach Anspruch 1, ferner mit einem Spaltendekoder (NG1), der mit dem Bitleitungspaar ($B_{11}$, $B_{12}$) verbunden ist und einen Abschaltmodus hat, der angeordnet ist, um die Transfergates (Q13, Q14) zu steuern, und bei dem der Kopplungsrauschenlöscher (CNP) angeordnet ist, um, unmittelbar bevor der Spaltendekoder (NG1) den Abschaltbetrieb aufnimmt, zu arbeiten.

3. Speicher nach Anspruch 2, bei dem der Spaltendekoder (NG1) eine Vielzahl von parallel angeschlossenen Transistoren umfaßt, die angeordnet sind, um Spaltenadresseneingangssignale (CAI) an ihren Gates zu empfangen, deren Sourcen angeschlossen sind, um die zweite Energieversorgungsspannung zu empfangen, und deren Drains gemeinsam angeschlossen sind, und einen Transistor ($Q_{21}$) vom Verarmungstyp, dessen Gate mit seiner Source verbunden und dessen Drain zum Empfang der ersten Energieversorgungsspannung (Vcc) verbunden ist.

4. Speicher nach Anspruch 3, bei dem der Spaltendekoder (NG1) ferner einen Steuertransistor ($Q_{22}$) umfaßt, der zwischen der Source des Transistors ($Q_{21}$) vom Verarmungstyp und den gemeinsam angeschlossenen Drains der genannten Vielzahl von parallel angeschlossenen Transistoren verbunden ist, dessen Gate zum Empfangen eines Steuersignals ($CS_2$) angeordnet ist, um den Spaltendekoder, durch Ausschalten des Steuertransistors ($Q_{22}$), in seinen Abschaltmodus zu bringen.

5. Speicher nach einem der vorhergehenden Ansprüche, bei dem der Leseverstärker (SA) einen Abschaltmodus hat, und bei dem der Kopplungsrauschenlöscher angeordnet ist, um, unmittelbar bevor der Leseverstärker (SA) den Abschaltbetrieb beginnt, zu arbeiten.

6. Speicher nach Anspruch 5, bei dem der Leseverstärker (SA) einen Lasttransistor ($Q_{28}$, $Q_{29}$) vom Verarmungstyp und zwei getriebene Transistoren ($Q_{26}$, $Q_{27}$) umfaßt, von denen jeder Lasttransistor ($Q_{28}$, $Q_{29}$) seinen Source-Drain-Weg in Reihe mit dem Source-Drain-Weg eines jeweiligen getriebenen Transistors ($Q_{26}$, $Q_{27}$) zwischen der ersten Energieversorgungsspannung und einem Knotenpunkt ($N_2$) verbunden hat, jeder Lasttransistor sein Gate mit einem gemeinsamen Verbindungspunkt seines Source-Drain-Weges mit demjenigen des in Reihe verbundenen Source-Drain-Weges eines getriebenen Transistors angeschlossen hat, und jeder getriebene Transistor sein Gate mit einem jeweiligen Datenbus des Datenbuspaares ($DB_1$, $DB_2$) verbunden hat, wobei der Leseverstärker (SA) ferner einen Steuertransistor ($Q_{23}$) umfaßt, dessen Source-Drain-Weg zwischen dem genannten Knotenpunkt ($N_2$) und der zweiten Energieversorgungsspannung verbunden ist, und dessen Gate zum Empfangen eines Steuersignals ($CS_2$) angeordnet ist, um den Leseverstärker durch Ausschalten des Steuertransistors ($Q_{23}$) in seinen Abschaltmodus zu bringen.

7. Speicher nach einem der Ansprüche 1 bis 6, bei dem der Kopplungsrauschenlöscher (CNP) ferner eine Lasteinrichtung ($Q_{33}$, $Q_{34}$) umfaßt, die zwischen der ersten Energieversorgungsspannung (Vcc) und den Datenbussen des Datenbuspaares (DB$_1$, DB$_2$) angeschlossen ist, die betreibbar ist, um jene Busse an ein vorbestimmten Potential zu koppeln, und eine Kurzshlußeinrichtung (Q$_{35}$), die zwischen den Datenbussen des Datenbuspaares (DB$_1$, DB$_2$) angeschlossen und betreibbar ist, um die Potentiale zwischen jenen Datenbussen auszugleichen.

8. Speicher nach Anspruch 7, bei dem die genannte Lasteinrichtung zwei Transistoren (Q$_{33}$, Q$_{34}$) umfaßt, deren Source-Drain-Wege zwischen der ersten Energieversorgungsspannung (Vcc) und den jeweiligen Datenbussen des genannten Datenbuspaares (DB$_1$, DB$_2$) verbunden sind, und deren Gates zum Empfang des Rauschlöschungs-Steuersignals (CS$_1$) angeschlossen sind, und bei dem die genannte Kurzschlußeinrichtung einen Transistor (Q$_{35}$) umfaßt, dessen Source-Drain-Weg zwischen den jeweiligen Datenbussen des genannten Datenbuspaares (DB$_1$, DB$_2$) angeschlossen ist, und dessen Gate angeschlossen ist, um das Rauschlöschungs-Steuersignal (CS$_1$) zu empfangen.

9. Speicher nach Anspruch 1, ferner mit enem Vorverstärker (PA), der zwischen den Datenbussen des Datenbuspaares (DB$_3$, DB$_4$) und dem Leseverstärker (SA) angeschlossen ist, und der einen Abschaltmodus Hat.

10. Speicher nach Anspruch 9, ferner mit einem Spaltendekoder (CD), der betreibbar ist, um das Rauschlöschungs-Steuersignal zu liefern und um ein Steuersignal zum Abschalten des Vorverstärkers (PA) zu liefern.

11. Speicher nach Anspruch 10, bei dem der Spaltendekoder (CD) ein NOR-Glied (NG2) umfaßt, dessen Eingänge angeordnet sind, um Spaltenadressen-Eingangssignale (CAI) zu empfangen, und einen ersten Inverter (II), der einen Eingang hat, der angeordnet ist, um den Ausgang des Nor-Glieds (NG2) zu empfangen, und einen Ausgang, der das Rauschlöschungs-Steuersignal liefert, und einen zweiten Inverter (12), der einen Eingang hat, der angeordnet ist, um den Ausgang des ersten Inverters zu empfangen, und einen Ausgang, der das Steuersignal des Vorverstärkers (PA) bildet.

12. Speicher nach Anspruch 10 oder 11, bei dem der Vorverstärker (PA) umfaßt: einen Lasttransistor (Q$_{49}$), dessen Source-Drain-Weg zwischen der ersten Energieversorgungsspannung (Vcc) und einem Knotenpunkt (M) verbunden ist, und dessen Gate mit der ersten Energieversorgungsspannung (Vcc) verbunden ist, einen Transistor (Q$_{50}$), dessen Source-Drain-Weg zwischen dem Knotenpunkt (M) und der zweiten Engergieversorgungsspannung verbunden ist und dessen Gate zum Empfang des Steuersignals zum Abschalten des Vorverstärkers (PA) verbunden ist, und zwei weiteren Transistoren (Q$_{47}$, Q$_{48}$), deren Source-Drain-Weg jeweils zwischen dem Leseverstärker (SA) und dem Knotenpunkt (M) verbunden ist und deren Gate jeweils mit einem entsprechenden Datenbus des Datenbuspaares (DB$_3$, DB$_4$) verbunden ist.

## Revendications

1. Mémoire à semi-conducteurs statique, capable de fonctionner avec une première tension d'alimentation (Vcc) et une seconde tension d'alimentation plus basse que la première tension d'alimentation, et ayant un mode à basse alimentation, comprenant des cellules de mémorisation (MC11, MC12, MC21, MC22) connectées à des lignes de mot (W1, W2) correspondantes et connectées en parallèle à une paire de lignes de bit (B11, B12, B21, B22), des portes de transfert (Q13, Q14, Q41, Q42, Q43, Q44) connectées aux lignes de bit de la paire.de lignes de bit et pouvant être commandées pour connecter ces lignes de bit à des premières extrémités de bus respectifs d'une paire de bus de données (DB1, DB2, DB3, DB4), ainsi qu'un amplificateur de lecture (SA) connecté fonctionnellement à des secondes extrémités de bus respectives de la paire de bus de données, caractérisée en ce qu'elle comporte, en outre, un éliminateur de bruit de couplage (CNP) connecté à la paire de bus de données (DB1, DB2, DB3, DB4) pour décharger les bus respectifs de la paire de bus de données jusqu'à la seconde tension d'alimentation et pour fixer ces bus à un potentiel prédéterminé lorsque la mémoire est commutée au mode à basse alimentation, l'éliminateur de bruit de couplage (CNP) comprenant deux transistors (Q31, Q32, Q45, Q46) connectés par leurs circuits source-drain entre les bus de données respectifs de la paire de bus de données (DB1, DB2, DB3, DB4) et la seconde tension d'alimentation, et ayant leurs grilles agencées pour recevoir un signal de commande (CS1) de l'éliminateur de bruit afin de rendre ces transistors conducteurs en vue de la décharge des bus de données jusqu'à la seconde tension d'alimentation.

2. Mémoire selon la revendication 1, comprenant en outre un décodeur de colonne (NG1), connecté à la paire de lignes de bit (B11, B12) et ayant un mode à basse alimentation, agencé pour commander les portes de transfert (Q13, Q14) et dans laquelle l'éliminateur de bruit de couplage (CNP) est agencé pour fonctionner immédiatement avant que le décodeur de colonne (NG1) ne commence une opération à basse alimentation.

3. Mémoire selon la revendication 2, dans laquelle le décodeur de colonne (NG1) comporte des transistors connectés en parallèle et agencés pour recevoir des signaux d'entrée d'adresse de colonne (CAI) à leurs grilles, les sources des transistors étant connectées pour recevoir la seconde tension d'alimentation et les drains des transistors étant connectés en commun, ainsi qu'un transistor (Q21) du type à déplétion, dont la grille est connectée à la source de ce transistor et dont le drain est connecté pour recevoir la première tension d'alimentation (Vcc).

4. Mémoire selon la revendication 3, dans laquelle le décodeur de colonne (NG1) comporte en outre un transistor de commande (Q22), connecté entre la source du transistor (Q21) du type à déplétion et les drains connectés en commun desdits transistors connectés en parallèle, la grille du transistor de commande étant agencée pour recevoir un signal de commande (CS2) destiné à amener le décodeur de colonne à son mode à basse alimentation par le blockage du transistor de commande (Q22).

5. Mémoire selon l'une quelconque des revendications précédentes, dans laquelle l'amplificateur de lecture (SA) a un mode à basse alimentation et dans laquelle l'éliminateur de bruit de couplage est agencé pour fonctionner immédiatement avant que l'amplificateur de lecture (SA) ne commence une opération à basse alimenatation.

6. Mémoire selon la revendication 5, dans laquelle l'amplificateur de lecture (SA) comporte deux transistors de charge (Q28; Q29) du type à déplétion et deux transistors pilotés (Q26, Q27), chacun des transistors de charge (Q28, Q29) étant connecté par son circuit source-drain en série avec le circuit source-drain d'un transistor piloté (Q26, Q27) respectif, entre la première tension d'alimentation et un noeud (N2), chaque transistor de charge étant connecté par sa grille au point de connexion commun de son circuit source-drain à celui du circuit source-drain d'un transistor piloté, avec lequel il est monté en série, et chaque transistor piloté étant connecté par sa grille à un bus de données respectif de la paire de bus de données (DB1, DB2), l'amplificateur de lecture (SA) comprenant, en outre, un transistor de commande (Q23) connecté par son circuit source-drain entre ledit noeud (N2) et la seconde tension d'alimentation et ayant sa grille agencée pour recevoir un signal de commande (CS2) pour amener l'amplificateur de lecture à son mode à basse alimentation par le blocage du transistor de commande (Q23).

7. Mémoire selon l'une quelconque des revendications 1 à 6, dans laquelle l'éliminateur de bruit de couplage (CNP) comporte, en outre, un dispositif de charge (Q33, Q34), connecté entre la première tension d'alimentation (Vcc) et les bus de données de la paire de bus de données (DB1, DB2), dispositif de charge qui est destiné à coupler ces bus au potentiel prédéterminé, ainsi qu'un dispositif de mise en court-circuit (Q35), connecté entre les bus de données de la paire de bus de données (DB1, DB2) et destiné à égaliser les potentiels de ces bus de données.

8. Mémoire selon la revendication 7, dans laquelle le dispositif de charge est constitué de deux transistors (Q33, Q34) dont les circuits source-drain sont connectés entre la première tension d'alimentation (Vcc) et les bus de données respectifs de la paire de bus de données (DB1, DB2) et dont les grilles sont connectées pour recevoir le signal de commande (CS1) de l'éliminateur de bruit de couplage, et le dispositif de mise en court-circuit est constitué d'un transistor (Q35) dont le circuit source-drain est connecté entre les bus de données respectifs de la paire de bus de données (DB1, DB2) et dont la grille est connectée pour recevoir le signal de commande (CS1) de l'éliminateur de bruit.

9. Mémoire selon la revendication 1, comprenant en outre un préamplificateur (PA), connecté entre les bus de données de la paire de bus de données (DB3, DB4) et l'amplificateur de lecture (SA) et ayant un mode à basse alimentation.

10. Mémoire selon la revendication 9, comprenant en outre un décodeur de colone (CD) destiné à fournir le signal de commande de l'éliminateur de bruit et à fournir un signal de commande pour la mise à basse alimentation du préamplificateur (PA).

11. Mémoire selon la revendication 10, dans laquelle le décodeur de colonne (CD) comporte une porte NON-OU (NG2) dont les entrées sont agencées pour recevoir des signaux d'entrée d'adresse de colonne (CAI), un premier inverseur (I1) possédant une entrée agencée pour recevoir le signal de sortie de la porte NON—OU (NG2) et une sortie fournissant le signal de commande de l'éliminateur de bruit, de même qu'un second inverseur (12) possédant une entrée agencée pour recevoir le signal de sortie du premier inverseur et une sortie fournissant le signal de commande pour le préamplificateur (PA).

12. Mémoire selon la revendication 10 ou 11, dans laquelle le préamplificateur (PA) comporte un transistor de charge (Q49) dont le circuit source-drain est connecté entre la première tension d'alimentation (Vcc) et un noeud (M) et dont la grille est connectée à la première tension d'alimentation (Vcc), un transistor de commande (Q50) dont le circuit source-drain est connecté entre le noeud (M) et la seconde tension d'alimentation et dont la grille est connectée pour recevoir le signal de commande pour la mise à basse alimenation du premplificateur (PA), ainsi que deux autres transistors (Q47, Q48) qui sont chacun connectés par leur circuits source-drain entre l'amplificateur de lectune (SA) et le noeud (M) et dont la grille est connectée à un bus de données respectif de la paire de bus de données (DB3, DB4).

FIG. 1

0 031 715

# FIG. 2

# FIG. 3

# FIG. 4

FIG. 5

FIG. 6A

FIG. 6B

NO CANCELLER
CIRCUIT ADDED

CANCELLER
CIRCUIT ADDED

VOLTAGE

TIME

STAND BY

ACTIVE

0 031 715